# EUROPÄISCHE PATENTSCHRIFT

(11) **EP 2 230 765 B1**
(45) Veröffentlichungstag und Bekanntmachung des Hinweises auf die Patenterteilung: **02.05.2012**
(21) Anmeldenummer: 09155237.2
(22) Anmeldetag: 16.03.2009
(51) Int. Cl.: H03K 17/955, H03K 17/96

(54) **Sensorvorrichtung, Verfahren zum Erfassen einer Bedienhandlung und Bedienvorrichtung**
Sensor device, method for detecting an operator control action and operating device
Dispositif de capteur, procédé de saisie de l'action d'un opérateur et dispositif de commande

(43) Veröffentlichungstag der Anmeldung: 22.09.2010
(73) Patentinhaber: Siemens Aktiengesellschaft, 80333 München (DE)
(72) Erfinder: Rehmann, Florian, 90419 Nürnberg (DE)

(56) Entgegenhaltungen:
- WO-A-87/02846
- DE-A1- 19 956 630
- JP-A- 5 075 422
- US-A1- 2009 045 823

## Beschreibung

Die Erfindung betrifft eine Sensorvorrichtung zum Erfassen einer Bedienhandlung an einem elektrischen Bauteil, wobei ein kapazitives Verhalten des elektrischen Bauteils mit einem Messmittel erfassbar ist.

Des Weiteren betrifft die Erfindung ein Verfahren zum Erfassen einer Bedienhandlung an einem elektrischen Bauteil, wobei ein kapazitives Verhalten des elektrischen Bauteils mit einem Messmittel ermittelt wird.

Auch betrifft die Erfindung eine Bedienvorrichtung zur Bedienung eines technischen Prozesses aufweisend eine Sensorvorrichtung.

Kapazitive Sensortechnik wird nach dem Stand der Technik bereits mit speziell angefertigten Sensoren eingesetzt. Kapazitive Sensoren arbeiten auf der Basis einer Veränderung einer Kapazität eines einzelnen Kondensators oder eines ganzen Kondensatorsystems. Eine Kapazitätsänderung kann beispielsweise infolge eines Durchbiegens einer Membrane und der damit resultierenden Änderung eines Plattenabstandes des Kondensators als Sensoreffekt ausgewertet werden. Die Membran wird hierbei beispielsweise als eine Kondensatorplatte ausgebildet.

Derartige Kapazitätssensoren befinden sich nach dem Stand der Technik beispielsweise in Folientastaturen von Bedieneinrichtungen. Auch können Sensor ersetzende Strukturen im Kupfer der Leiterplatten eingesetzt werden.

In der DE 199 56 630 A1 wird ein kapazitiver Tastschalter offenbart.

Weiterhin sind Anwendungen mit sensitiven LED's bekannt, wobei die LED's die Reflektionen des imitierten Lichtes messen, welche bei einer Annäherung, beispielsweise durch einen Finger einer menschlichen Hand, reflektiert werden. Nachteilig an dieser Anwendung ist es daher, dass die LED entweder selber leuchten muss, oder eine andere verlässliche Lichtquelle aufweisen muss.

In der WO 87/02846 A wird eine touch sensitive Leuchtdiode offenbart, nachteilig an dieser Diode ist es, dass sie zusätzliche Elektroden aufweisen muss.

Die JP 05 075422 A zeigt eine Leuchtdiode, welche mit zwei Sensorringen umgeben ist und somit auch zusätzliche Elektroden benötigt.

Die US 2009/0045823 A1 offenbart eine kapazitive Sensoranordnung mit Mitteln den Energieverbrauch einer solchen Anordnung zu minimieren.

Bei Bedieneinheiten mit Folientastaturen und eingesetzten mechanischen Schnappscheiben ist es von Nachteil, dass diese Schnappscheiben zur Registrierung einer Bedienhandlung einem mechanischen Verschleiß unterliegen.

Der Erfindung liegt deshalb die Aufgabe zugrunde, eine Sensorvorrichtung anzugeben, welche keinem mechanischen Verschleiß unterliegt bzw. zur Ermittlung einer Bedienhandlung nicht selber aktiviert ist.

Die Aufgabe wird durch eine Sensorvorrichtung mit den Merkmalen des Anspruchs 1 gelöst, dabei ist ein Steuermittel mit einem dem elektrischen Bauteil vorgeschalteten Schaltmittel zur Steuerung des Schaltmittels verbunden und dass Steuermittel derart ausgestaltet, dass es auf ein Ausgabesignal des Messmittels das elektrische Bauteil mittels des Schaltmittels in einen stromlosen Zustand versetzt. Da elektrische Bauteile parasitäre Kapazitäten aufweisen, kann mit den elektrischen Bauteilen und den an sich ungewünschten parasitären Kapazitäten ein kapazitiver Sensor aufgebaut werden. Bei der Nutzung eines derartigen kapazitiven Sensors zur Erfassung einer Bedienhandlung werden die elektrischen Eigenschaften der parasitären Kapazität gemessen. Diese werden u.a. charakterisiert durch das elektrische Feld in einem Kondensator, welches beispielsweise durch das in die Nähe bringen eines Fingers zur Bedienung verändert werden kann. Diese Veränderung kann mittels der Messmittel erfasst werden. Bevorzugt wird dabei durch das Messmittel einem Steuermittel mitgeteilt, dass im Folgenden eine Messung an dem elektrischen Bauteil zur Bestimmung der parasitären Kapazität durchgeführt werden soll. Das Steuermittel wiederum setzt beispielsweise einen Befehl zu einem Schaltmittel ab, welches als ein Treiberbaustein für das elektrische Bauelement ausgestaltet sein kann. Durch den Befehl des Steuermittels an das Schaltmittel kann im Beispiel des Treiberbausteins der Treiberbaustein in einen vorbestimmten Zustand versetzt werden, vorzugsweise in einen stromlosen Zustand für das nachfolgende von ihm zu treibende elektrische Bauteil. In diesem stromlosen Zustand herrschen dann definierte Bedingungen, welche für eine nachfolgende Messung an dem elektrischen Bauteil zur Bestimmung der parasitären Kapazität mit Vorteil genutzt werden können.

In einer bevorzugten Ausgestaltung ist das Messmittel über eine erste Signalleitung und eine zweite Signalleitung zum Laden oder Entladen einer Kapazität an das elektrische Bauteil angeschlossen. Die zu ladende Kapazität stellt innerhalb des elektrischen Bauteils die bereits erwähnte parasitäre Kapazität eines jeden Bauteils dar.

In einer weiteren vorteilhaften Ausgestaltung ist das Messmittel über eine dritte Signalleitung zur Ermittlung eines transienten Vorgangs einer Zustandsgröße an das elektrische Bauteil angeschlossen. Durch ein Laden bzw. ein Entladen der parasitären Kapazität des elektrischen Bauteils können Messkurven ermittelt werden, welche Aufschluss über den Wert der Kapazität geben. Diese Messkurven geben vorzugsweise die Zustandsgrößen eines Kondensators bzw. des Bauteils wieder. Als Zustandsgröße wird dabei diejenige physikalische Größe bezeichnet, die das elektrische Verhalten eines Bauteils beschreibt.

Beispielsweise kann eine Zustandsgröße den Energieinhalt eines Energiespeichers beschreiben. Ein Anfangswert und ein Endwert der Zustandsgröße sollten bei einer Messung bekannt sein. Beispielsweise für Zustandsgrößen sind ein Strom I, eine Spannung U eine Ladungsmenge Q.

Dabei ist es weiterhin von Vorteil, wenn das Messmittel Mittel zur Zeitermittlung der sich beim Laden und Entladen ergebenen Zeiten aufweist. Anhand des zeitlichen Verlaufs der Lade- bzw. Entladekurven kann die allgemeine Zeitkonstante τ = R · C ermittelt werden und daraus die parasitäre Kapazität bzw. die Kapazitätsänderung bei Annäherung, durch beispielsweise einen Finger einer menschlichen Hand, ermittelt werden.

Bevorzugt weist das Messmittel Vergleichsmittel zum Vergleichen der Zeiten mit Referenzzeiten auf. Beispielsweise gilt ein Ladevorgang bzw. ein Entladevorgang eines Kondensators nach 5τ als abgeschlossen.

Die Leuchtdiode wird somit als ein "Touch-LED-Sensor" genutzt. Da Leuchtdioden in der Regel fest eingebaut sind und daher nicht beweglich sind, sind sie mechanisch nahezu verschleißfrei. Als weiterer Vorteil wird gesehen, dass sie im Gegensatz zu mechanischen Schaltern wesentlich kleiner und preisgünstiger ausgeführt werden können. Darüber hinaus können bereits in einem Bediengerät eingebaute LED's als Tast-LED's oder Touch-LED-Sensoren erweitert werden. Im Vergleich zu lichtsensitiven LED-Sensoren ist die kapazitive Messung unabhängig von Umgebungslicht oder dem Leuchtstatus der LED. Eine Aussage, ob die LED mit einem Finger berührt wurde, kann somit auch erfolgen wenn die LED nicht leuchtet. Verfahrensgemäß wird die eingangs genannte Aufgabe durch die Merkmale des Anspruchs 6 gelöst. Das Messmittel wird dazu vor einer Durchführung einer Messung einem dem elektrischen Bauteil vorgeschaltetem Schaltmittel über eine Steuerleitung, einen Schaltbefehl zum Deaktivieren des elektrischen Bauteiles für die Zeitdauer der Messung übermitteln. Wenn sich das elektrische Bauteil in einem deaktivierten Zustand befindet, herrschen definierte Messbedingungen und eine Messung an dem elektrischen Bauteil kann mit einer hohen Genauigkeit durchgeführt werden.

Vorteilhafter Weise wird eine Kapazität des elektrischen Bauteils über Signalleitungen geladen oder entladen.

Bevorzugt wird dabei ein transienter Vorgang einer Zustandsgröße der Kapazität über eine dritte Signalleitung ermittelt. In einer bevorzugten Weise setzt sich bei dem Verfahren ein Messvorgang durch folgende Schritte zusammen: Während des Ladevorgangs der Kapazität wird eine Ladezeit, bis ein bestimmter erster Spannungswert erreicht wird gemessen und der Ladevorgang damit abgeschlossen, um mit dem Entladevorgang fortzusetzen und dabei eine Entladezeit zu Messen wird die Entladezeit solange beobachtet bis ein zweiter Spannungswert erreicht wird und damit wird die Entladezeit gemessen.

Zur Auswertung der in dem Bauteil vorherrschenden, insbesondere parasitären Kapazität, wird die Ladezeit und die Entladezeit mit Referenzwerten verglichen und daraus eine Aussage getroffen, ob das elektrische Bauteil aufgrund einer Annäherung bedient wurde.

Zur Erhöhung einer Genauigkeit können mehrere Messzyklen aufeinanderfolgen.

Bezug nehmend auf eine Bedienvorrichtung im industriellen Umfeld, wo raue Umweltbedingungen, wie Staub, Feuchtigkeit, Ölbelastungen und Vibrationen herrschen, ist eine Bedienvorrichtung zur Bedienung eines technischen Prozesses aufweisend eine Sensorvorrichtung nach einem der Ansprüche 1 bis 5 wegen einer erheblich geringeren Störanfälligkeit der erfindungsgemäß ausgestalteten Sensoren mit großen Vorteil einsetzbar.

Weitere Vorteile und Merkmale werden anhand des Ausführungsbeispiels in der Zeichnung näher beschrieben. Es zeigen:
- FIG 1: ein Blockschaltbild einer Sensorvorrichtung und
- FIG 2: ein Detailschaltbild der Sensorvorrichtung aus FIG 1.

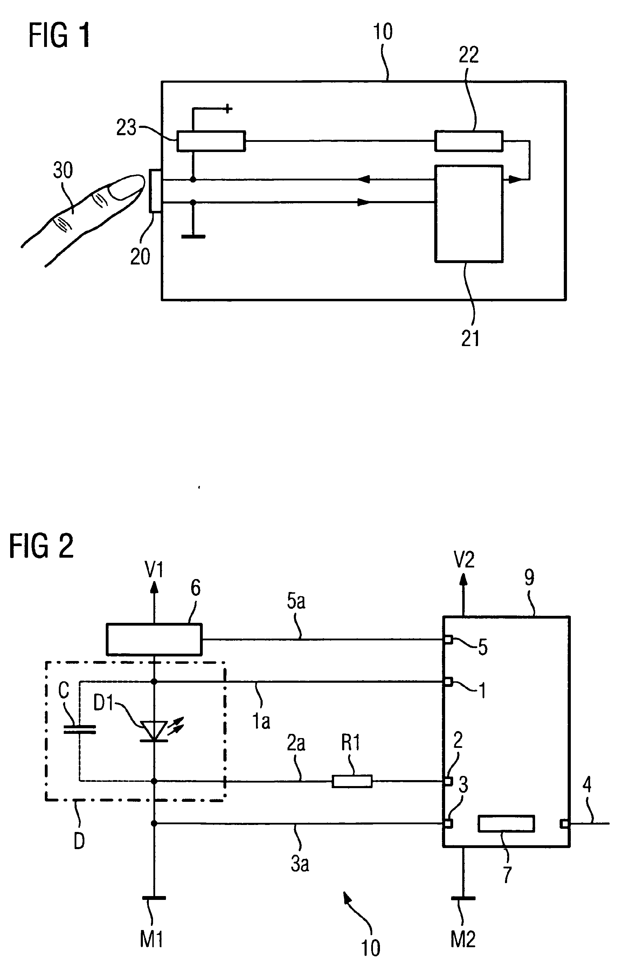

Gemäß FIG 1 ist eine Sensorvorrichtung 10 mit einem elektrischen Bauteil 20 dargestellt. Die Sensorvorrichtung 10 dient dem Erfassen einer Bedienhandlung an dem elektrischen Bauteil 20, wobei ein kapazitives Verhalten des elektrischen Bauteils 20 mit einem Messmittel 21 erfassbar ist. Ein Steuermittel 22 steht mit dem Messmittel 21 über eine Signalleitung in Verbindung. Des Weiteren ist das Steuermittel 22 über eine weitere Signalleitung mit einem Schaltmittel 23 verbunden.

Das Schaltmittel 23 ist für den Fall, dass das elektrische Bauteil 20 als beispielsweise eine LED ausgestaltet ist, als ein LED-Treiber ausgestaltet. Das Schaltmittel 23 wird dazu genutzt das elektrische Bauteil entweder zu Aktivieren oder zu Deaktivieren. Über eine dem Schaltmittel 23 zugeführte Plusleitung kann über das Schaltmittel 23 ein Strom über das Bauteil 20 geführt werden und zu einem Masseanschluss abgeführt werden. An das elektrische Bauteil 20 sind zwei weitere Signalleitungen herangeführt, welche mit dem Messmittel 21 in Verbindung stehen. Symbolisch durch Pfeile ist angedeutet, dass das Messmittel 21 zum Einen einen Ladestrom zu dem elektrischen Bauteil 20 schicken kann und zum Anderen einen Entladestrom vom elektrischen Bauteil 20 empfangen kann. Soll durch das Messmittel 21 eine Messung an dem elektrischen Bauteil 20 durchgeführt werden, so wird an einer Ausgangsseite des Messmittels 21 ein Signal an das Steuermittel 22 weitergeleitet und dieses leitet das Signal weiter an das Schaltmittel 23. Das Schaltmittel 23 kann aufgrund des weitergeleiteten Signals nun das elektrische Bauteil 20 in einen vordefinierten Zustand versetzen und das Messmittel 21 kann für die Zeitdauer, in der sich das elektrische Bauteil 20 in dem vordefinierten Zustand befindet, die Messung durchführen.

FIG 2 zeigt die in FIG 1 schematisch anhand eines Blockschaltbildes beschriebene Sensorvorrichtung 10 in einer Detailausgestaltung. Das Messmittel 21 ist nun als ein Mikrocontroller 9 ausgestaltet. Der Mikrocontroller 9 weist einen ersten Anschluss 1, einen zweiten Anschluss 2, einen dritten Anschluss 3 und einen vierten Anschluss 4 auf. An den ersten Anschluss 1 ist eine erste Signalleitung 1a angeschlossen. Die erste Signalleitung 1a ist anodenseitig an eine Leuchtdiode D angeschlossen. Über den zweiten Anschluss 2 ist mittels einer zweiten Signalleitung 2a, in der als eine Reihenschaltung ein Widerstand R1 geschaltet ist, eine Kathodenseite der Leuchtdiode D mit dem zweiten Anschluss 2 des Mikrocontrollers 9 verbunden. Weiterhin ist der dritte Anschluss 3 über eine dritte Signalleitung 3a mit einem Masseanschluss M1, welcher ebenfalls an der Kathodenseite der Leuchtdiode D angeschlossen ist, verbunden.

Die Leuchtdiode D ist hier mittels eines Ersatzschaltbildes dargestellt. Die Leuchtdiode D besteht somit aus einer Parallelschaltung aus einem Kondensator C und einer inneren Diode Dl. Der Kondensator C ist gestrichelt gezeichnet um anzudeuten, dass es sich hierbei um eine parasitäre Kapazität des Bauteils Leuchtdiode D handelt. Die Leuchtdiode D wird über einen LED-Treiberbaustein 6, welcher eine Verbindung zu einer ersten Versorgungsspannung V1 aufweist, mit einer Betriebsspannung versorgt, die Leuchtdiode D kann damit zum Leuchten angeregt werden. Der durch die erste Versorgungsspannung V1 entstehende Potentialunterschied zwischen einem Einspeisepunkt und dem ersten Masseanschluss M1 sorgt damit für einen Stromfluss durch die Leuchtdiode D bzw. durch den Kondensator C und die innere Leuchtdiode D1 welche parallel geschaltet sind. Der LED-Treiberbaustein 6 kann über eine Steuerleitung 5a aktiviert werden bzw. deaktiviert werden. Der Mikrocontroller 9 stellt an einem fünften Anschluss 5, welcher als ein Ausgang ausgebildet ist, ein Steuersignal bereit, welches den LED-Treiberbaustein 6 erreicht und dafür sorgt das dieser den Stromfluss durch die Leuchtdiode D unterbricht. Diese Unterbrechung wird genutzt um über den ersten Anschluss 1 und den zweiten Anschluss 2 des Mikrocontrollers 9 eine Messung durchzuführen. Die Messung teilt sich auf in eine Aufladephase gefolgt von einer Entladephase. In der Aufladephase wird über den zweiten Anschluss 2 des Mikrocontrollers 9 über den Widerstand R1 eine Spannung zum Aufladen des Kondensators C an die Kathodenseite der Leuchtdiode D angelegt. Dieser Ladestrom der nun während des Ladevorgangs durch den Kondensator C fließt gelangt über die erste Signalleitung 1a zurück zum ersten Anschluss 1 des Mikrocontrollers 9. Der Mikrocontroller 9 treibt also über den zweiten Anschluss 2 eine "1" und lädt den parasitären Kondensator der LED über den Widerstand R1 auf. Der erste Anschluss 1 des Mikrocontrollers 9 treibt dabei eine "0".

Ein in den Mikrocontroller 9 integriertes Mittel zur Zeitermittlung 7, ein sogenannter "Timer" misst die Zeit bis ein vorher bestimmbarer Spannungswert erreicht wird. Ist der vorher eingestellte Spannungswert erreicht, schaltet der Mikrocontroller 9 von der Aufladephase in eine Entladephase um. Dazu wird der erste Anschluss 1 und der zweite Anschluss 2 auf Nullpotential geschaltet, sie treiben also eine "0". Der Kondensator C kann sich durch diese Einstellung des Mikrocontrollers 9 somit Entladen und eine Spannung an dem dritten Anschluss 3 nimmt kontinuierlich ab. Es wird wiederum die Zeit gemessen, bis ein vorher eingestellter Spannungswert unterschritten wird. Diese Abnahme der Spannung stellt eine Ermittlung einer Zustandsgröße dar.

Je nach dem, ob das elektrische Feld des Kondensators C der Leuchtdiode D beeinflusst wird oder nicht, ergeben sich unterschiedliche Lade- und Entladezeiten. Aus diesen unterschiedlichen Lade- und Entladezeiten können Rückschlüsse auf eine an der Leuchtdiode D vorgenommene Bedienhandlung durch Annäherung eines Fingers 30 erfasst werden. Um eine Genauigkeit der Messung zu erhöhen, ist es denkbar mehrere Messzyklen direkt aufeinanderfolgen zu lassen und dann das Ergebnis auszuwerten.

Vorzugsweise findet die Messung statt während die Leuchtdiode D ausgeschaltet ist. Wenn die Leuchtdiode D betriebsbedingt eingeschaltet ist, wird sie für die Dauer der Messung ausgeschaltet. Dieses Ausschalten wird durch das bereits beschriebene Aussenden eines Steuerbefehls über die Steuerleitung 5a und dem fünften Anschluss 5 des Mikrocontrollers 9 an den LED-Treiberbaustein 6 realisiert. Ein Ausschalten der LED = Leuchtdiode D für die Dauer der Messung kann für einen kurzen Zeitraum erfolgen, dieser Zeitraum des nicht Leuchtens der LED = Leuchtdiode D ist für das menschliche Auge kaum erfassbar und die LED = Leuchtdiode D wird dem Betrachter dadurch nur etwas dunkler erscheinen, aber nicht flackernd. Ein Verlust an Helligkeit der Leuchtdiode D kann durch Erhöhen des Stromes in den Leuchtphasen wieder angepasst werden.

Eine LED wird somit als eine verschleißfreie beleuchtbare Taste eingesetzt.

## Patentansprüche

1. Sensorvorrichtung (10) mit einem elektrischen Bauteil (20) zum Erfassen einer Bedienhandlung an dem elektrischen Bauteil (20), wobei ein kapazitives Verhalten des elektrischen Bauteils (20) mit einem Messmittel (21) erfassbar ist, wobei das elektrische Bauteil (20) als eine Leuchtdiode (D) ausgestaltet ist, wobei ein Steuermittel (22) mit einem dem elektrischen Bauteil (20) vorgeschalteten Schaltmittel (23) zur Steuerung des Schaltmittels (23) verbunden ist, **dadurch gekennzeichnet, dass** das Steuermittel (22) derart ausgestaltet ist, dass es auf ein Ausgabesignal des Messmittels (21) das elektrische Bauteil (20) mittels des Schaltmittels in einen stromlosen Zustand versetzt, wobei in dem stromlosen Zustand eine definierte Bedingung an dem elektrischen Bauteil (20) herrscht, welche für eine nachfolgende Messung an dem elektrischen Bauteil (20) zur Bestimmung der parasitären Kapazität des elektrischen Bauteils (20) genutzt wird.

2. Sensorvorrichtung (10) nach Anspruch 1,
wobei das Messmittel (21) über eine erste Signalleitung (1a) und eine zweite Signalleitung (2a) zum Laden oder Entladen einer Kapazität (C) an das elektrische Bauteil (20) angeschlossen ist.

3. Sensorvorrichtung (10) nach Anspruch 1 oder 2,
wobei das Messmittel (21) über eine dritte Signalleitung (3a) zur Ermittlung eines transienten Vorgangs einer Zustandsgröße der Kapazität (C) an das elektrische Bauteil (20) angeschlossen ist.

4. Sensorvorrichtung (10) nach einem der Ansprüche 2 bis 3,
wobei das Messmittel (21) Mittel (7) zur Zeitermittlung der sich beim Laden und Entladen ergebenen Zeiten aufweist.

5. Sensorvorrichtung (10) nach Anspruch 4,
wobei das Messmittel (21) Vergleichsmittel zum Vergleichen der Zeiten mit Referenzzeiten aufweist.

6. Verfahren zum Erfassen einer Bedienhandlung an einem elektrischen Bauteil (20), wobei ein kapazitives Verhalten des elektrischen Bauteils (20) mit einem Messmittel (21) ermittelt wird, wobei zum Erfassen einer Bedienung mit einem Zeigemittel eine Leuchtdiode (D) als elektrisches Bauteil (20) eingesetzt wird, **dadurch gekennzeich** - **net**, dass das Messmittel (21) vor einer Durchführung einer Messung einem dem elektrischen Bauteil (20) vorgeschaltetem Schaltmittel (23) über eine Steuerleitung (5a) einen Schaltbefehl zum Deaktivieren des elektrischen Bauteils (20) für die Zeitdauer der Messung übermittelt, wobei das elektrische Bauteil (20) durch die Deaktivierung in einen stromlosen Zustand versetzt wird, wobei in dem stromlosen Zustand eine definierte Bedingung an dem elektrischen Bauteil (20) herrscht, welche für eine nachfolgende Messung an dem elektrischen Bauteil (20) zur Bestimmung der parasitären Kapazität des elektrischen Bauteils (20) genutzt wird.

7. Verfahren nach Anspruch 6,
wobei eine Kapazität (C) des elektrischen Bauteils (20) über Signalleitungen (1a,2a) geladen oder entladen wird.

8. Verfahren nach Anspruch 7,
wobei ein transienter Vorgang einer Zustandsgröße der Kapazität (C) über eine dritte Signalleitung (3a) ermittelt wird.

9. Verfahren nach einem der Ansprüche 7 oder 8,
wobei während des Ladevorgangs der Kapazität (C) eine Ladezeit, bis ein bestimmbarer erster Spannungswert erreicht wird, gemessen wird und der Ladevorgang damit abgeschlossen wird um mit dem Entladevorgang fortzusetzen und dabei eine Entladezeit bis ein zweiter bestimmbarer Spannungswert erreicht wird, gemessen wird.

10. Verfahren nach Anspruch 9,
wobei die Ladezeit und die Entladezeit mit Referenzwerten verglichen werden und daraus eine Aussage getroffen wird, ob das elektrische Bauteil (20) aufgrund einer Annäherung bedient wurde.

11. Verfahren nach einem der Ansprüche 6 bis 10,
wobei zur Erhöhung einer Genauigkeit mehrere Messzyklen aufeinanderfolgen.

12. Bedienvorrichtung zur Bedienung eines technischen Prozesses aufweisend eine Sensorvorrichtung (10) nach einem der Ansprüche 1 bis 5.

## Claims

1. Sensor device (10) having an electrical component (20) for detecting an operator control action at the electrical component (20), wherein a capacitive behaviour of the electrical component (20) can be detected by a measuring means (21), wherein the electrical component (20) is embodied as a light-emitting diode (D), wherein a control means (22) is connected to a switching means (23) connected in circuit upstream of the electrical component (20) for the purpose of controlling the switching means (23), **characterised in that** the control means (22) is embodied in such a way that in response to an output signal of the measuring means (21) it places the electrical component (20) into a currentless state with the aid of the switching means, wherein in the currentless state there prevails at the electrical component (20) a defined condition which is used for a subsequent measurement at the electrical component (20) for the purpose of determining the parasitic capacitance of the electrical component (20).

2. Sensor device (10) according to claim 1,
wherein the measuring means (21) is connected to the electrical component (20) via a first signal line (1a) and a second signal line (2a) for the purpose of charging or discharging a capacitor (C).

3. Sensor device (10) according to claim 1 or 2,
wherein the measuring means (21) is connected to the electrical component (20) via a third signal line (3a) for the purpose of determining a transient operation of a state variable of the capacitor (C).

4. Sensor device (10) according to one of claims 2 to 3, wherein the measuring means (21) has means (7) for determining the times resulting during charging and discharging.

5. Sensor device (10) according to claim 4,
wherein the measuring means (21) has comparison means for comparing the times with reference times.

6. Method for detecting an operator control action at an electrical component (20), wherein a capacitive behaviour of the electrical component (20) is determined with the aid of a measuring means (21), wherein a light-emitting diode (D) is employed as an electrical component (20) for detecting an operator control action using an indicating means,
**characterised in that** prior to performing a measurement the measuring means (21) transmits a switching command to a switching means (23) connected in circuit upstream of the electrical component (20) via a control line (5a) for the purpose of deactivating the electrical component (20) for the duration of the measurement, wherein the electrical component (20) is placed into a currentless state as a result of the deactivation, wherein in the currentless state there prevails a defined condition at the electrical component (20) which is used for a subsequent measurement at the electrical component (20) for the purpose of determining the parasitic capacitance of the electrical component (20).

7. Method according to claim 6,
wherein a capacitor (C) of the electrical component (20) is charged or discharged via signal lines (1a,2a).

8. Method according to claim 7,
wherein a transient operation of a state variable of the capacitor (C) is determined via a third signal line (3a).

9. Method according to one of claims 7 or 8,
wherein during the charging operation of the capacitor (C) a charging time until a determinable first voltage value is reached is measured and the charging operation is thereby terminated in order to continue with the discharging operation and in the process a discharging time until a second determinable voltage value is reached is measured.

10. Method according to claim 9,
wherein the charging time and the discharging time are compared with reference values and on the basis thereof a deduction is made as to whether the electrical component (20) was subject to an operator control action as a result of being approached.

11. Method according to one of claims 6 to 10,
wherein a plurality of measurement cycles are performed in succession in order to increase a degree of precision.

12. Operator control device for controlling a technical process, comprising a sensor device (10) according to one of claims 1 to 5.

## Revendications

1. Dispositif ( 10 ) de capteur ayant un élément ( 20 ) électrique pour la détection de l'action d'un opérateur sur l'élément ( 20 ) électrique, un comportement capacitif de l'élément ( 20 ) électrique pouvant être détecté par un moyen ( 21 ) de mesure, l'élément ( 20 ) électrique étant conformé en diode ( D ) électroluminescente, un moyen ( 22 ) de commande étant, pour la commande du moyen ( 23 ) de commutation, relié au moyen ( 23 ) de commutation monté devant l'élément ( 20 ) électrique, **caractérisé en ce que** le moyen ( 22 ) de commande est tel que, sur un signal d'émission du moyen ( 21 ) de mesure, il met l'élément ( 20 ) électrique à l'aide du moyen de commutation dans un état sans courant, dans lequel il règne sur l'élément ( 20 ) électrique une condition définie qui est utilisée pour une mesure venant ensuite sur l'élément ( 20 ) électrique pour la détermination de la capacité parasite de l'élément ( 20 ).

2. Dispositif ( 10 ) de capteur suivant la revendication 1, dans lequel le moyen ( 21 ) de mesure est raccordé à l'élément ( 20 ) électrique par une première ligne ( 1a ) de signal et par une deuxième ( 2a ) de signal pour la charge ou la décharge d'une capacité ( C ).

3. Dispositif ( 10 ) de capteur suivant la revendication 1 ou 2, dans lequel le moyen ( 21 ) de mesure est raccordé à l'élément ( 20 ) électrique par une troisième ligne ( 3a ) de signal pour la détermination d'une valeur transitoire d'une grandeur d'état de la capacité ( C ).

4. Dispositif ( 10 ) de capteur suivant l'une des revendications 2 à 3,
dans lequel le moyen ( 21 ) de mesure comporte un moyen ( 7 ) de détermination des temps de charge et de décharge.

5. Dispositif ( 10 ) de capteur suivant la revendication 4, dans lequel le moyen ( 21 ) de mesure comporte un moyen de comparaison pour la comparaison des temps à des temps de référence.

6. Procédé de détection de l'action d'un opérateur sur un élément ( 20 ) électrique, dans lequel on détermine un comportement capacitif de l'élément ( 20 ) électrique par un moyen ( 21 ) de mesure, dans lequel pour la détection d'une opération par un moyen d'indication on utilise une diode ( D ) électroluminescente comme élément ( 20 ) électrique, **caractérisé en ce que** le moyen ( 21 ) de mesure transmet, avant d'effectuer une mesure, à un moyen ( 23 ) de commutation monté avant l'élément ( 20 ) électrique, par une ligne ( 5a ) de commande, une instruction de commutation pour la désactivation de l'élément ( 20 ) électrique pendant la durée de la mesure, l'élément ( 20 ) électrique étant mis par la désactivation dans un état sans courant, dans lequel dans l'état sans courant il règne sur l'élément ( 20 ) électrique une condition définie qui est utilisée pour une mesure venant ensuite sur l'élément ( 20 ) électrique pour la détermination de la capacité parasite de l'élément ( 20 ).

7. Procédé suivant la revendication 6,
dans lequel on charge ou on décharge une capacité ( C ) du composant ( 20 ) électrique par des lignes ( 1a, 2a ) de signal.

8. Procédé suivant la revendication 7,
dans lequel on détermine une valeur transitoire d'une grandeur d'état de la capacité ( C ) par une troisième ligne ( 3a ) de signal.

9. Procédé suivant l'une des revendications 7 ou 8,
dans lequel pendant l'opération de charge de la capacité ( C ), on mesure un temps de charge jusqu'à ce qu'une première valeur de tension pouvant être déterminée soit atteinte et on met fin ainsi à l'opération de charge pour poursuivre par l'opération de décharge et on mesure un temps de décharge jusqu'à ce qu'une deuxième valeur de tension pouvant être déterminée soit atteinte.

10. Procédé suivant la revendication 9,
dans lequel on compare le temps de charge et le temps de décharge à des valeurs de référence et on en tire une prédiction sur le point de savoir si sur la base d'une approximation le composant ( 20 ) électrique a été manipulé.

11. Procédé suivant l'une des revendications 6 à 10,
dans lequel, pour augmenter la précision, on fait se succéder plusieurs cycles de mesure.

12. Dispositif de commande d'un processus technique comportant un dispositif ( 10 ) de capteur suivant l'une des revendications 1 à 5.
